(19) Europäisches Patentamt
European Patent Office
Office européen des brevets

(11) **EP 1 528 425 B1**

(12) **EUROPÄISCHE PATENTSCHRIFT**

(45) Veröffentlichungstag und Bekanntmachung des Hinweises auf die Patenterteilung:
**08.09.2010 Patentblatt 2010/36**

(51) Int Cl.:
*G02B 27/09* (2006.01)     *G02B 6/42* (2006.01)
*H01S 3/00* (2006.01)

(21) Anmeldenummer: **03024780.3**

(22) Anmeldetag: **30.10.2003**

(54) **Anordnung und Vorrichtung zur optischen Strahlbündeltransformation**

Assembly and device for optical beam transformation

Assemblage et appareillage pour la transformation de faisceaux optiques

(84) Benannte Vertragsstaaten:
**AT BE BG CH CY CZ DE DK EE ES FI FR GB GR HU IE IT LI LU MC NL PT RO SE SI SK TR**

(43) Veröffentlichungstag der Anmeldung:
**04.05.2005 Patentblatt 2005/18**

(73) Patentinhaber: **LIMO Patentverwaltung GmbH & Co. KG
36419 Gerstengrund (DE)**

(72) Erfinder: **Mikhailov, Aleksei
44227 Dortmund (DE)**

(74) Vertreter: **Basfeld, Rainer et al
Fritz Patent- und Rechtsanwälte
Postfach 1580
59705 Arnsberg (DE)**

(56) Entgegenhaltungen:
**EP-A- 1 006 382     EP-A- 1 176 450
WO-A-90/13054     DE-A- 10 113 019
US-A- 4 203 652**

**Beschreibung**

Die vorliegende Erfindung betrifft eine Anordnung zur optischen gemäß dem Oberbegriff des Anspruchs 7. Weiterhin betrifft die vorliegende Erfindung eine Vorrichtung zur optischen Strahltransformation gemäß dem Oberbegriff des Anspruchs 1.

Eine Anordnung sowie eine Vorrichtung der vorgenannten Art sind aus der europäischen Patentanmeldung EP 1 006 382 A1 bekannt. Die darin beschriebene Vorrichtung umfasst beispielsweise ein Substrat aus einem transparenten Material, das eine Eintrittsfläche und eine Austrittsfläche aufweist. Sowohl die Eintrittsfläche als auch die Austrittsfläche sind im Wesentlichen rechteckförmig ausgebildet und langgestreckt. Die Längserstreckung der Eintrittsfläche und der Austrittsfläche entspricht im Wesentlichen der zweiten Richtung. Wenn als Lichtquelle ein Laserdiodenbarren verwendet wird, entspricht diese zweite Richtung der Richtung, in der einzelne Emitter des Laserdiodenbarrens nebeneinander und beabstandet voneinander angeordnet sind. Diese Richtung geringerer Divergenz wird Slow-Axis genannt. Die dazu senkrechte erste Richtung ist die Richtung größerer Divergenz, die bei Halbleiterlaserdiodenbarren Fast-Axis genannt wird.

Bei der aus dem vorgenannten Stand der Technik bekannten Vorrichtung sind sowohl auf der Eintrittsfläche als auch auf der Austrittsfläche eine Mehrzahl von Zylinderlinsen vorgesehen, deren Zylinderachsen sämtlich parallel zueinander ausgerichtet sind. Die Zylinderachsen der Zylinderlinsen auf der Eintrittsfläche und der Austrittsfläche schließen sowohl mit der Slow-Axis als auch mit der Fast-Axis jeweils einen Winkel von 45° beziehungsweise - 45° ein. Ein von einem emittierenden Abschnitt eines Laserdiodenbarrens ausgehender Lichtstrahl, der letztlich linienförmig in Slow-Axis-Richtung ausgedehnt ist, wird bei dem Hindurchtritt durch die aus dem Stand der Technik bekannte Vorrichtung zur optischen Strahltransformation um 90° gedreht, so dass der Lichtstrahl nach dem Hindurchtritt durch die Vorrichtung linienförmig in Fast-Axis-Richtung ausgebildet ist. Eine derartige Vorrichtung bietet den Vorteil, dass durch die Drehung der einzelnen Lichtstrahlen die Überlappung der einzelnen Lichtstrahlen in Slow-Axis-Richtung erschwert wird.

Als nachteilig bei dieser aus dem Stand der Technik bekannten Vorrichtung erweist sich, dass der Querschnitt des Strahles bei dem Hindurchtritt durch die Vorrichtung insgesamt vergrößert wird, weil die sämtlich zueinander parallelen Zylinderlinsen den Strahl nur in einer zur Ausbreitungsrichtung senkrechten Richtung beeinflussen, wohingegen die zu dieser einen Richtung senkrechte Richtung durch die Vorrichtung beziehungsweise durch die Zylinderlinsen der Vorrichtung in keinerlei Hinsicht beeinflusst wird. Dadurch läuft der Strahl in dieser Richtung auseinander, so dass die durch die Vorrichtung hindurchgetretenen einzelnen Teilstrahlen nach dem Hindurchtritt nur vergleichsweise schwer auf einen gemeinsamen Fokuspunkt fokussierbar sind. Dies hat unter anderem auch seinen Grund darin, dass hinsichtlich einer zu der Ausbreitungsrichtung senkrechten Richtung hinter der Vorrichtung eine Abbildung der einzelnen Emitter der beispielsweise als Laserdiodenbarren ausgeführten Lichtquelle geschaffen wird, wohingegen dies hinsichtlich der anderen zur Ausbreitungsrichtung und zu der vorgenannten Richtung senkrechten Richtung nicht der Fall ist. Weiterhin kann die Aufweitung des Strahles während des Hindurchtritts durch die Vorrichtung dazu führen, dass die einzelnen Teilstrahlen zumindest teilweise überlappen, so dass allein aus diesem Grund schon keine saubere Fokussierung sämtlicher Teilstrahlen auf einen gemeinsamen Fokusbereich möglich ist.

Aus der DE 101 13 019 A1 sind eine Anordnung und eine Vorrichtung zur Strahlformung bekannt. Die darin beschriebene Vorrichtung kann den Querschnitt eines von einem Laserdiodenbarren ausgehenden Lichtstrahls verkleinern. Dazu umfasst die Vorrichtung einen Spiegel, der den Lichtstrahl hinsichtlich seines Querschnitts in zwei gleich große Hälften teilt. Eine dieser Hälften des Lichtstrahls wird dann umgelenkt und mittels eines Polarisationswürfels mit der anderen Hälfte so überlagert, dass insgesamt die Vorrichtung ein Lichtstrahl mit einem Querschnitt verlässt, der in der Slow-Axis-Richtung verkleinert ist und in der Fast-Axis-Richtung vergrößert ist.

Aus der EP 1 176 450 A2 sind eine Anordnung sowie eine Vorrichtung bekannt, die denen der EP 1 006 382 A1 sehr ähnlich sind. Bei der Vorrichtung gemäß EP 1 176 450 A2 sind lediglich die Zylinderlinsen auf den Eintritts- und Austrittsfläche durch toroidale Flächen ersetzt. Die Ersetzung der zylindrischen Flächen durch toroidale Flächen kann zur Vermeidung von astigmatischen Abbildungsfehlern beitragen, weil ein zusätzlicher Freiheitsgrad zur Gestaltung der Flächen zur Verfügung steht.

Aus Fig. 20(a) und 20(b) der US-A-4 203 652 sind Vorrichtungen zur Strahltransformation von Laserstrahlen bekannt, die von einem Halbleiterlaser ausgehen. Eine der Vorrichtungen kollimiert dabei die von der Austrittsebene des Halbeleiterlasers ausgehende Laserstrahlung mittels einer sphärischen Bikonvexlinse. Der Querschnitt der derart kollimierten Laserstrahlung wird durch ein anamorphes Linsensystem hinsichtlich einer Richtung senkrecht zur Ausbreitungsrichtung der Laserstrahlung verkleinert. Daran anschließend wird die Laserstrahlung mittels einer weiteren sphärischen Bikonvexlinse in einen Punkt fokussiert. In der Ausführungsform gemäß Fig. 4(a) und 4(b) offenbart die US-A-4 203 652 ein anamorphes Linsensystem aus einer bikonvexen Zylinderlinse und einer bikonkaven Zylinderlinse, deren Zylinderachsen senkrecht zu einander ausgerichtet sind. Dieses anamorphe Linsensystem kann die Laserstrahlung eines Halbleiterlasers, dessen Licht von zwei in Ausbreitungsrichtung hintereinander liegenden Ebenen auszugehen scheint, hinsichtlich seiner Divergenz derart transformieren, dass das Licht nach Hindurchtritt durch das anamorphe System von einer Ebene auszugehen scheint.

Das der vorliegenden Erfindung zugrundeliegende Problem ist die Schaffung einer Anordnung und einer Vorrichtung der eingangs genannten Art, die einen besser fokussierbaren Lichtstrahl nach Hindurchtritt durch die Vorrichtung ermöglichen.

Dies wird erfindungsgemäß hinsichtlich der Anordnung durch eine Anordnung der eingangs genannten Art mit den kennzeichnenden Merkmalen des Anspruchs 7 sowie hinsichtlich der Vorrichtung durch eine Vorrichtung der eingangs genannten Art mit den kennzeichnenden Merkmalen des Anspruchs 1 ermöglicht.

Durch die Erzeugung eines Abbildes hinsichtlich zweier zueinander senkrechter Richtungen in einer Ebene wird die Fokussierbarkeit des Lichtstrahles hinsichtlich dieser beiden zueinander senkrechten Richtungen deutlich verbessert. Insbesondere kann ein derartiger Strahl ohne zusätzliche Abbildungsfehler fokussiert werden. Durch die Ausrichtung von Zylinderlinsen auf einigen der Flächen senkrecht zu den Zylinderlinsen auf anderen der Flächen kann erreicht werden, dass der mindestens eine durch die Vorrichtung hindurchtretende Lichtstrahl hinsichtlich zweier zueinander senkrechter Richtungen durch die Vorrichtung beeinflusst wird. Insbesondere durch die Kombination von konkaven und konvexen Zylinderlinsen, die dabei hintereinander angeordnet sein können, kann erreicht werden, dass hinsichtlich der beiden zueinander senkrechten Richtungen ein Abbild in ein und derselben Ebene erzeugt werden kann.

Es kann vorgesehen sein, dass die Vorrichtung derart gestaltet ist, dass die Querschnittsfläche des mindestens einen Lichtstrahles in der Vorrichtung zur optischen Strahltransformation verkleinert wird. Durch die Verkleinerung des mindestens einen Lichtstrahles in der Vorrichtung kann wirkungsvoll verhindert werden, dass mehrere durch die Vorrichtung hindurchtretende Lichtstrahlen während des Hindurchtrittes durch die Vorrichtung oder kurz dahinter miteinander überlappen. Die Verkleinerung kann beispielsweise in zwei zueinander senkrechten und zur Ausbreitungsrichtung senkrechten Richtungen gleich stark sein, insbesondere etwa einem Faktor zwei entsprechen.

Es kann vorgesehen sein, dass die Ebene, in der das Abbild des zu transformierenden Lichtstrahles erzeugt werden kann, eine zu der Ausbreitungsrichtung senkrechte Ebene ist.

Es kann vorgesehen sein, dass die Zylinderlinsen mit der zweiten Richtung einen Winkel von + 45° und/oder - 45° einschließen.

Weiterhin kann dabei vorgesehen sein, dass die Eintritts- und Austrittsflächen der Vorrichtung eine im Wesentlichen langgestreckte, vorzugsweise rechteckige Form aufweisen, wobei die Längsrichtung der Eintritts- und Austrittsflächen im Wesentlichen der zweiten Richtung entspricht.

Es kann vorgesehen sein, dass für mindestens eines der Teile die Brennweiten der Zylinderlinsen auf ihren Eintritts- und/oder Austrittsflächen unterschiedlich sind. Durch unterschiedliche Brennweiten von hintereinander angeordneten Zylinderlinsen kann beispielsweise im Rahmen einer Teleskopanordnung eine Verkleinerung des Querschnittes des Lichtstrahles ermöglicht werden. Letztlich kann eine Teleskopanordnung dadurch erzielt werden, dass der Abstand der Zylinderlinsen auf der Eintrittsfläche und der Austrittsfläche des jeweiligen. Teiles der Summe der Brennweiten dieser Zylinderlinsen entspricht.

Es kann vorgesehen sein, dass die Anordnung in Ausbreitungsrichtung des mindestens einen Lichtstrahles hinter der Vorrichtung zur optischen Strahltransformation Kollimiermittel und/oder Fokussiermittel für die Kollimierung und/oder Fokussierung des mindestens einen Lichtstrahles umfasst.

Weiterhin kann vorgesehen sein, dass die mindestens eine Lichtquelle als Halbleiterlaservorrichtung, insbesondere als Halbleiterlaserdiodenbarren ausgeführt ist.

Weitere Merkmale und Vorteile der vorliegenden Erfindung werden deutlich anhand der nachfolgenden Beschreibung bevorzugter Ausführungsbeispiele unter Bezugnahme auf die beiliegenden Abbildungen. Darin zeigen

Fig. 1a    eine Seitenansicht einer erfindungsgemäßen Anordnung zur optischen Strahlentransformation;

Fig. 1b    eine Draufsicht auf die Anordnung gemäß Fig. 1a;

Fig. 2    eine perspektivische Ansicht einer erfindungsgemäßen Vorrichtung zur optischen Strahltransformation;

Fig. 3a    ein Detail eines Schnittes längs den Pfeilen IIIa-IIIa in Fig. 2;

Fig. 3b    ein Detail eines Schnittes längs den Pfeilen IIIb-IIIb in Fig. 2;

Fig. 4a    ein beispielhafter Strahlengang durch die erfindungsgemäße Vorrichtung in der in Fig. 3a abgebildeten Ebene;

Fig. 4b    ein beispielhafter Strahlengang durch die Vorrichtung in der in Fig. 3b abgebildeten Ebene;

Fig. 5    der Querschnitt eines Lichtstrahles vor und nach dem Hindurchtritt durch die Vorrichtung gemäß Fig. 2;

Fig. 6    eine perspektivische Ansicht einer weiteren Ausführungsform einer erfindungsgemäßen Anordnung;

Fig. 7     eine Hinteransicht der Vorrichtung zur optischen Strahltransformation gemäß Fig. 6 mit dahinter befindlichem Kollimationsmittel.

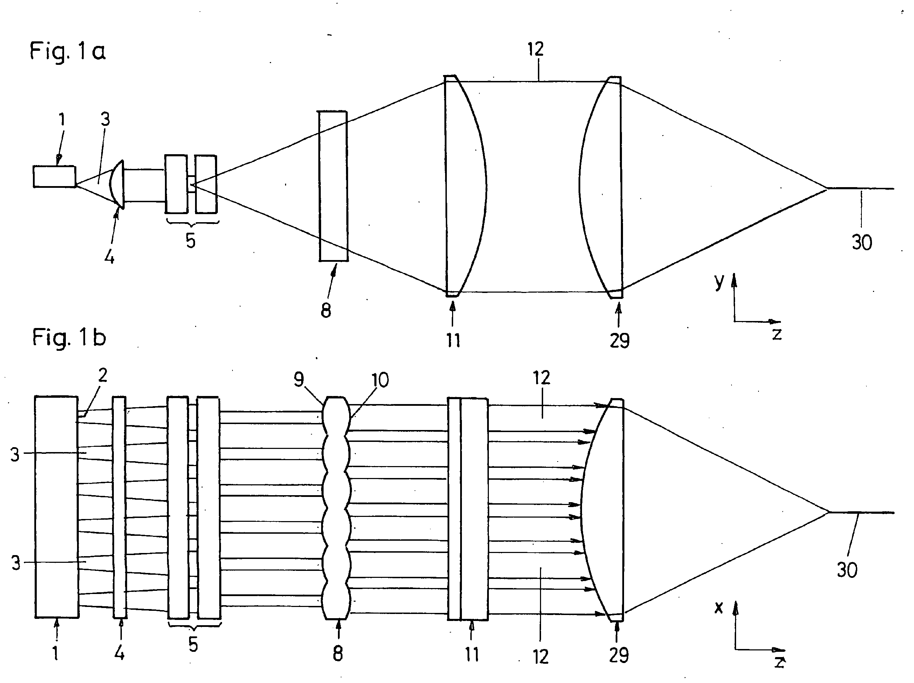

In den Fig. 1a bis Fig. 7 sind zur besseren Orientierung kartesische Koordinatensysteme eingezeichnet.

Die aus Fig. 1a und Fig. 1b ersichtliche Ausführungsform einer erfindungsgemäßen Anordnung umfasst eine als Laserdiodenbarren ausgeführte Lichtquelle 1 die in X-Richtung nebeneinander angeordnete und voneinander in X-Richtung beabstandete emittierende Abschnitte aufweist. Die von den einzelnen emittierenden Abschnitten 2 ausgehenden Lichtstrahlen weisen in einer ersten, der Y-Richtung entsprechenden Richtung eine deutlich größere Divergenz auf als in einer zweiten, der X-Richtung entsprechenden Richtung. Es ist allgemein üblich, die Richtung größerer Divergenz "Fast-Axis" und die Richtung kleinerer Divergenz "Slow-Axis" zu nennen.

In Ausbreitungsrichtung Z hinter den emittierenden Abschnitten 2 umfasst die abgebildete Anordnung ein als Fast-Axis-Kollimationslinse ausgebildetes Kollimationsmittel 4. Dieses Kollimationsmittel 4 kann eine plankonvexe Zylinderlinse sein, deren Zylinderachse sich in X-Richtung erstreckt. Insbesondere kann diese Zylinderlinse eine sehr kleine Brennweite aufweisen und sehr nahe an den emittierenden Abschnitten 2 angeordnet sein.

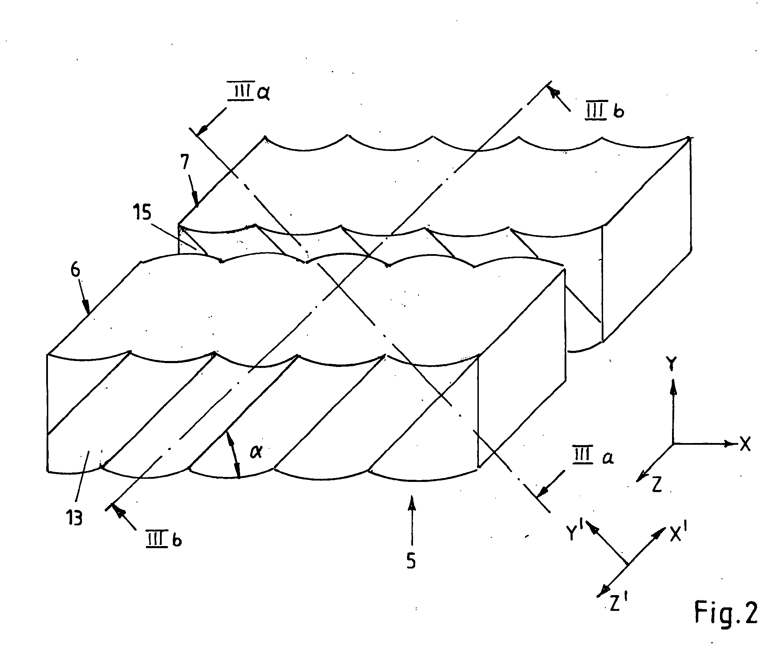

In Ausbreitungsrichtung Z hinter dem Kollimationsmittel 4 ist eine erfindungsgemäße Vorrichtung 5 zur optischen Strahltransformation angeordnet. Die Vorrichtung 5 besteht in dem abgebildeten Ausführungsbeispiel aus zwei separaten Teilen 6, 7, die in Ausbreitungsrichtung Z hintereinander angeordnet sind und jeweils eine Eintrittsfläche und eine Austrittsfläche aufweisen. Die Vorrichtung 5 wird im Nachfolgenden unter Bezugnahme auf die Fig. 2 bis Fig. 5 noch ausführlicher beschrieben.

Ein jeder der Lichtstrahlen 3 wird in der Vorrichtung 5 derart transformiert, dass sein Querschnitt verringert wird und dass gleichzeitig die Divergenz der X-Richtung mit der Divergenz der Y-Richtung getauscht wird. Dies hat insbesondere zur Folge, dass der Abstand der einzelnen Lichtstrahlen 3 in X-Richtung zueinander deutlich vergrößert wird. Es entstehen somit nicht mit Licht ausfüllte Bereiche zwischen den einzelnen Lichtstrahlen 3. Um eine bessere Fokussierbarkeit sämtlicher Lichtstrahlen 3 beispielsweise auf einen Punkt zu ermöglichen, ist in Ausbreitungsrichtung Z hinter der Vorrichtung 5 ein Linsenarray 8 vorgesehen, das sowohl auf der Eintrittsfläche als auch auf der Austrittsfläche Linsen 9, 10 aufweisen kann. Es handelt sich bei den Linsen 9, 10 um Zylinderlinsen, deren Zylinderachsen sich in Y-Richtung erstrecken. Durch dieses Linsenarray 8 werden die einzelnen Lichtstrahlen aufgeweitet, so dass der Abstand zwischen den einzelnen Lichtstrahlen in X-Richtung wesentlich geringer ist.

In Ausbreitungsrichtung Z hinter dem Linsenarray 8 kann eine Kollimierlinse 11 vorgesehen sein, die beispielsweise eine Zylinderlinse umfasst, deren Zylinderachse sich in X-Richtung erstreckt. Aus Fig. 1a und Fig. 1b ist deutlich ersichtlich, dass die einzelnen Lichtstrahlen 12 nach Hindurchtritt durch die Vorrichtung 5 in X-Richtung und somit in der ursprünglichen Slow-Axis keine oder lediglich beugungsbegrenzte Divergenz aufweisen, wohingegen die einzelnen Lichtstrahlen 12 in Y-Richtung und somit in der ursprünglichen Fast-Axis-Richtung eine Divergenz aufweisen, die der ursprünglichen Divergenz in Slow-Axis-Richtung vor Hindurchtritt durch die Vorrichtung 5 entspricht. Bei Hindurchtritt durch die Vorrichtung 5 sind somit die Divergenzen in Slow-Axis- und in Fast-Axis-Richtung getauscht worden. Daher kann durch die Kollimierlinse 11 die Restdivergenz in Fast-Axis-Richtung kollimiert werden. Die aus der Kollimierlinse 11 austretenden Lichtstrahlen 12 stellen somit im Wesentlichen paralleles Licht dar, das sehr einfach fokussierbar ist.

Aus Fig. 1a und Fig. 1b ist ersichtlich, dass die Lichtstrahlen 12 sowohl in X-Richtung als auch in Y-Richtung im Wesentlichen gleich ausgedehnt sind. Die Lichtstrahlen 12 könnten somit mit einer in positiver Z-Richtung hinter der Kollimierlinse 11 angeordneten Fokussierlinse 29 sehr effektiv auf die Eintrittsfläche einer Glasfaser 30 fokussiert werden.

Die Vorrichtung 5 zur optischen Strahltransformation besteht, wie dies beispielsweise aus Fig. 2 ersichtlich ist, aus einem ersten Teil 6 und einem zweiten Teil 7. Das Teil 6 weist auf seiner Eintrittsfläche eine Vielzahl von Zylinderlinsen 3 auf, deren Zylinderachsen unter einem Winkel von $\alpha$ = 45° zur X-Achse geneigt sind. In dem abgebildeten Ausführungsbeispiel sind nur sechs Zylinderlinsen 13 eingezeichnet. Es besteht jedoch durchaus die Möglichkeit deutlich mehr Zylinderlinsen 13 auf der Eintrittsfläche vorzusehen. Die Fig. 2 dient insofern nur zur vereinfachenden Darstellung.

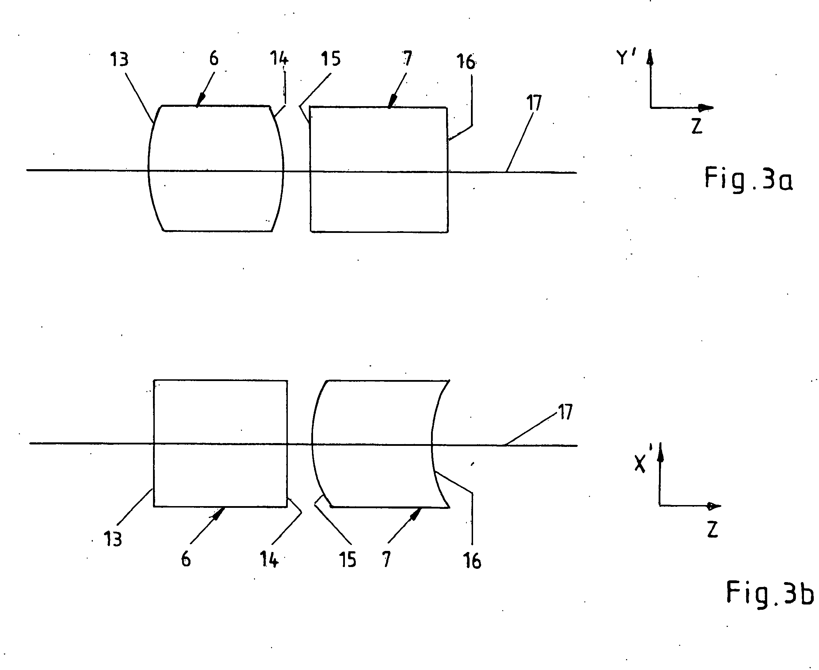

Auf der Austrittsfläche des Teiles 6 sind ebenfalls eine Vielzahl von Zylinderlinsen 14 angeordnet, deren Zylinderlinsen ebenfalls unter einem Winkel von $\alpha$ = 45° zur X-Achse geneigt sind. Dies ist noch einmal deutlich aus Fig. 3a ersichtlich, der entnehmbar ist, dass sowohl die Zylinderlinsen 13 als auch die Zylinderlinsen 14 konvex ausgebildet sind. Fig. 3a zeigt ein Detail eines Schnittes längs der Y'-Richtung, die in Fig. 2 eingezeichnet ist. Demgegenüber zeigt Fig. 3b eine um 90° gedrehte Ansicht, mithin ein Detail aus einem Schnitt längs der ebenfalls aus Fig. 2 ersichtlichen X'-Richtung. Dementsprechend erstrecken sich die Zylinderachsen der Zylinderlinsen 13, 14 in X'-Richtung.

Das zweite Teil 7 der Vorrichtung 5 weist auf seiner Eintrittsfläche ebenfalls konvexe Zylinderlinsen 15 auf. Die Zylinderachsen dieser Zylinderlinsen 15 erstrecken sich jedoch unter einem Winkel von 135° zur X-Richtung und damit längs der Y'-Richtung.

Das Teil 7 weist auf seiner Austrittsfläche konkave Zylinderlinsen 16 auf, deren ebenfalls parallel zueinander angeordnete Zylinderachsen ebenfalls einen Winkel von 135° mit der X-Richtung einschließen und sich somit ebenfalls in Y'-Richtung erstrecken.

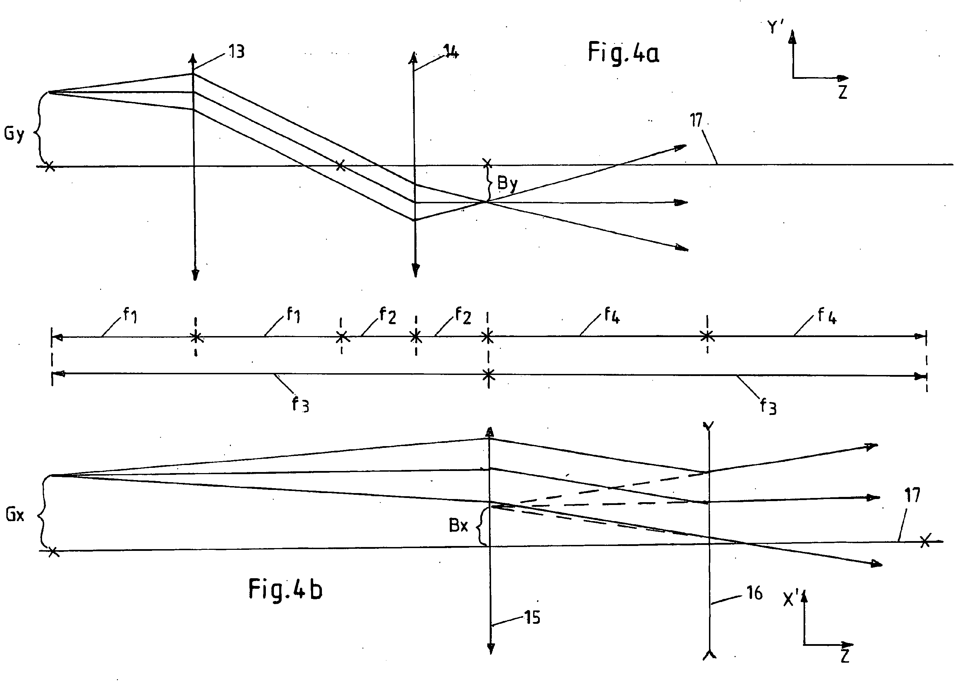

Aus Fig. 4a und 4b sind die Brennweiten der einzelnen Zylinderlinsen 13, 14, 15, 16 ersichtlich. Insbesondere ist mit $f_1$ die Brennweite der ersten Zylinderlinse 13 bezeichnet. Mit $f_2$ ist die Brennweite der zweiten Zylinderlinse 14 bezeichnet, wobei $f_1 = 2 * f_2$ ist. Mit $f_3$ ist die Brennweite der dritten Zylinderlinse 15 bezeichnet, wobei $f_3 = 2 * f_1 + 2 * f_2$ ist. Mit $f_4$ ist die Brennweite der vierten Zylinderlinse 16 bezeichnet, wobei $f_3 = 2 * f_4$ ist.

Insbesondere sind die Teile 6, 7 dabei derart angeordnet, dass der Abstand zwischen der zweiten Zylinderlinse 14, die auf der Austrittsfläche des Teiles 6 angeordnet ist, zu der dritten Zylinderlinse 15, die auf der Eintrittfläche des Teiles 7 angeordnet ist, der Brennweite $f_2$ der zweiten Zylinderlinse 14 entspricht.

Der optische Abstand der ersten Zylinderlinsen 13 zu den zweiten Zylinderlinsen 14 in Z-Richtung entspricht der Summe der beiden Brennweiten $f_1$, $f_2$ der Zylinderlinsen 13, 14. Dies ist aus Fig. 4a deutlich ersichtlich. Der optische Abstand der dritten Zylinderlinsen 15 zu den vierten Zylinderlinsen 16 in Z-Richtung entspricht der Brennweite $f_4$ der vierten Zylinderlinsen 16. Dies ist aus Fig. 4b deutlich ersichtlich.

Aus Fig. 4a und Fig. 4b lässt sich das Abbildungsverhalten der Vorrichtung 5 im Detail entnehmen. Insbesondere sind in Fig. 4a und Fig. 4b die Zylinderlinsen 13, 14, 15, 16 schematisch durch mit Pfeilen versehende Striche verdeutlicht. Auf der mit dem Bezugszeichen 17 versehenen optischen Achse des jeweiligen Linsensystems sind die Brennpunkte der einzelnen Linsen durch Kreuze angedeutet. Zwischen Fig. 4a und Fig. 4b sind die Lagen der einzelnen Brennweiten $f_1$, $f_2$, $f_3$, $f_4$ zusätzlich verdeutlicht.

An dieser Stelle soll angemerkt werden, dass die ersten Zylinderlinsen 13 und die zweiten Zylinderlinsen 14 aufgrund der Ausrichtung ihrer Zylinderachsen in X'-Richtung auf die Abstände von Lichtstrahlen in X'-Richtung zur optischen Achse keinen Einfluss nehmen. Daher sind die Zylinderlinsen 13, 14 des ersten Teiles 6 der Vorrichtung 5 in Fig. 4b nicht abgebildet. Analog nehmen auch die dritten Zylinderlinsen 15 und die vierten Zylinderlinsen 16 des zweiten Teils 7 aufgrund der Ausrichtung ihrer Zylinderachsen in Y'-Richtung auf die in Fig. 4a abgebildeten in Y'-Richtung zu der optischen Achse beabstandeten Lichtstrahlen keinen Einfluss, so dass die Zylinderlinsen 15, 16 des zweiten Teiles 7 in Fig. 4a nicht abgebildet sind. Die Zylinderlinsen 13, 14 des ersten Teiles 6 wirken somit nur hinsichtlich der Y'-Richtung als Linsen, wohingegen sie hinsichtlich der X'-Richtung keinen Einfluss auf durch sie hindurchtretende Lichtstrahlen haben. Entsprechend wirken die Zylinderlinsen 15, 16 des zweiten Teiles 7 nur hinsichtlich der X'-Richtung auf durch sie hindurchtretende Lichtstrahlen, wohingegen sie hinsichtlich der Y'-Richtung keinen Einfluss auf durch sie hindurchtretende Lichtstrahlen haben.

Aus Fig. 4a ist ersichtlich, dass ein in Y'-Richtung um eine Strecke $G_y$ von der optischen Achse 17 beabstandeter Punkt, der von der ersten Zylinderlinse 13 in Z-Richtung einen Abstand aufweist, der der Brennweite $f_1$ der ersten Zylinderlinse 13 entspricht, von dem durch die Zylinderlinsen 13, 14 gebildeten Abbildungssystem in einen Punkt abgebildet wird, der in Y'-Richtung einen Abstand $B_y$ von der optischen Achse 17 aufweist. Dieser Bildpunkt $B_y$ befindet sich dabei hinter der zweiten Zylinderlinse 14 in einem Abstand in Z-Richtung, der der Brennweite $f_2$ der zweiten Zylinderlinse 14 entspricht.

Fig. 4b zeigt die Abbildung des eine Strecke $G_x$ zur optischen Achse 17 in X'-Richtung beabstandeten Punkte durch das durch die dritten und vierten Zylinderlinsen 15, 16 gebildete Abbildungssystem. Aufgrund der Ausführung der vierten Zylinderlinsen 16 als Zerstreuungslinsen ergibt sich durch das vorgenannte in Fig. 4b abgebildete Abbildungssystem eine Abbildung, die ein virtuelles Bild erzeugt, das bei dem abgebildeten Ausführungsbeispiel in Z-Richtung exakt an der gleichen Stelle entsteht, an der sich die dritten Zylinderlinsen 15 befinden. Dieses virtuelle Bild weist einen Abstand $B_x$ in X'-Richtung zur optischen Achse auf, der halb so groß ist wie der Abstand $G_x$. Das durch die dritten und vierten Zylinderlinsen 15, 16 gebildete Abbildungssystem verkleinert also den Querschnitt eines durch das Abbildungssystem hindurchtretende Lichtstrahles um einen Faktor 2. Weiterhin lässt sich Fig. 4b entnehmen, dass das virtuelle Bild in X'-Richtung auf der gleichen Seite der optischen Achse 17 angeordnet ist, so dass von einer Abbildung mit M = + ½ gesprochen werden kann.

Demgegenüber wird bei dem durch die ersten und zweiten Zylinderlinsen 13, 14 gebildeten Abbildungssystem eine verkleinernde Abbildung auf der gegenüberliegenden Seite der optischen Aschse 17 erzielt. Insbesondere ist auch hier die Strecke $G_y$ doppelt so groß wie die Strecke $B_y$, so dass hier von einer Abbildung mit M = - ½ gesprochen werden kann.

Als sehr großer Vorteil ist bei der erfindungsgemäßen Vorrichtung 5 anzusehen, dass die Abbildungen sowohl des in Fig. 4a abgebildeten Abbildungssystems aus den ersten und zweiten Zylinderlinsen 13, 14 als auch des in Fig. 4b dargestellten, aus den dritten und vierten Zylinderlinsen 15, 16 gebildeten, Abbildungssystems in der gleichen X'- Y'-Ebene beziehungsweise X-Y-Ebene liegen und somit in der gleichen Ebene hinsichtlich der Z-Richtung. Es entsteht somit hinsichtlich der Ausbreitungsrichtung Z an einer vorgebbaren Stelle ein Bild, das sowohl hinsichtlich der X'-Richtung als auch hinsichtlich der Y'-Richtung vorgebbare Eigenschaften aufweist. Dieses Bild kann sehr einfach von nachfolgenden Linsenmitteln kollimiert beziehungsweise fokussiert werden.

Bei einer erfindungsgemäßen Vorrichtung ist es letztlich nicht entscheidend, an welcher Stelle die Linsen 13, 14, 15, 16 angeordnet sind, sondern dass die beiden hinsichtlich der X'-Richtung und Y'-Richtung erzeugten Bilder in der gleichen X'-Y'-Ebene beziehungsweise der gleichen X-Y-Ebene liegen. Beispielsweise muss nicht unbedingt das Bild B$_x$ exakt an der Z-Position entstehen, an der sich auch die Zylinderlinse 15 befindet. Dieses Bild B$_x$ kann hinter oder vor der Zylinderlinse 15 entstehen.

Weiterhin besteht durchaus auch die Möglichkeit, dass die beiden Teile 6, 7 der Vorrichtung 5 auf ihrer Eintrittsfläche und ihrer Austrittsfläche Zylinderlinsen aufweisen, deren Zylinderachsen senkrecht zueinander ausgebildet sind. Beispielsweise könnte somit eine lediglich auf die X'-Richtung wirkende Zylinderlinse wie die Zylinderlinse 15, auf der Austrittsfläche des ersten Teiles 6 angeordnet werden, wohingegen dann eine nur auf die Y'-Richtung wirkende Zylinderlinse wie die Zylinderlinse 14 auf der Eintrittsfläche des zweiten Teils 7 angeordnet sein kann. Es muss lediglich sichergestellt sein, dass aufgrund der gewählten Brennweiten f$_1$, f$_2$, f$_3$, f$_4$ und der entsprechenden Positionen der Zylinderlinsen 13, 14, 15, 16 die hinsichtlich der X'-Richtung oder der Y'-Richtung entstehenden Bilder B$_x$ und B$_y$ in der gleichen Ebene senkrecht zur Z-Richtung entstehen.

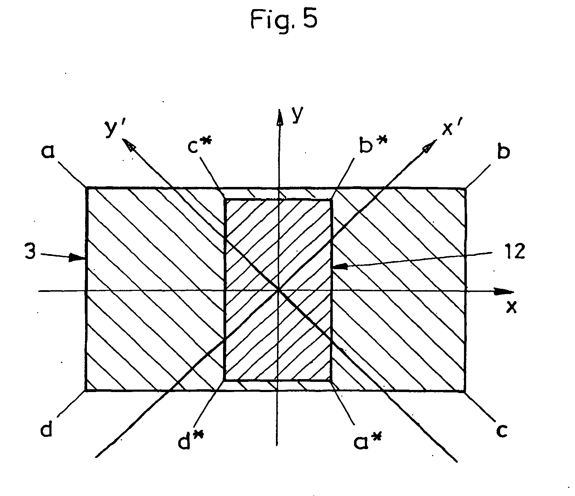

Aus Fig. 5 ist noch einmal schematisch der Querschnitt eines Lichtstrahles 3 vor dem Hindurchtritt durch die Vorrichtung 5 und der Querschnitt des durch die Vorrichtung 5 hindurchgetretenen Lichtstrahles 12 ersichtlich. Insbesondere ist deutlich, dass der Querschnitt des Lichtstrahles 3 in beiden Richtungen etwa halbiert wurde. Die Fig. 5 zeigt, dass der Lichtstrahl 3 vor dem Hindurchtritt durch die Vorrichtung 5 einen im Wesentlichen rechteckigen Querschnitt aufweist. Die Ecken dieses rechteckigen Querschnittes sind mit den Buchstaben a, b, c, d bezeichnet.

Der Querschnitt des durch die Vorrichtung 5 hindurchgetretenen Lichtstrahles 12 ist ebenfalls rechteckig, wobei die Ecken dieses Rechteckes mit dem Buchstaben a*, b*, c*, d* bezeichnet sind. Es zeigt sich, dass das vorher in X-Richtung langgestreckte Rechteck des Querschnitts des Lichtstrahles 3 in ein sich nach dem Hindurchtritt in Y-Richtung erstreckendes Rechteck des Querschnitts des Lichtstrahles 12 verwandelt wurde. Weiterhin ist die Verkleinerung des Querschnittes deutlich ersichtlich. Die durch die Vorrichtung 5 ausgeübte Strahltransformation hat an dem Lichtstrahl 3 beziehungsweise dem Lichtstrahl 12 eine Drehung um die Ausbreitungsrichtung Z um 90° mit anschließender Spiegelung an einer zu der Ausbreitungsrichtung Z parallelen Ebene bewirkt, die durch die Y-Richtung hindurchgeht. Letztlich bewirkt die an dem Lichtstrahl 3 beziehungsweise dem Lichtstrahl 12 vorgenommene Strahltransformation neben der Verkleinerung des Querschnittes eine Vertauschung der Divergenzen in der Slow-Axis-Richtung (X-Richtung) und der Fast-Axis-Richtung (Y-Richtung). Dies wird bei aus dem Stand der Technik bekannten Vorrichtungen zur Strahltransformation in der Regel durch einfache Drehungen um 90° erreicht.

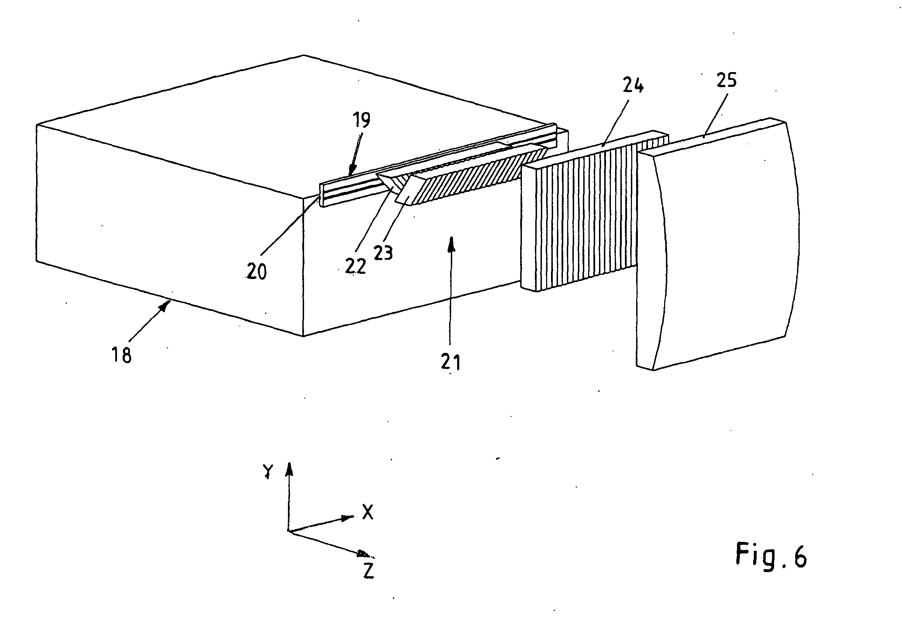

Aus Fig. 6 ist eine weitere Ausführungsform einer erfindungsgemäßen Anordnung ersichtlich, die im Prinzip sehr ähnlich zu der aus Fig. 1a und Fig. 1b ersichtlichen Anordnung aufgebaut ist. Insbesondere ist hier die Lichtquelle 18 als Halbleiterlaservorrichtung mit einem vergleichsweise großen Kühlkörper ausgeführt. Das eigentliche Halbleiterlaserelement ist in Fig. 6 nicht ersichtlich. Weiterhin sind die Fokussierlinse 29 und die Glasfaser 30 nicht abgebildet. Im Anschluss an die Lichtquelle 18 ist ein Kollimationsmittel 19 ersichtlich, das als vergleichsweise ausgedehntes Glassubstrat mit einer darin ausgebildeten als Fast-Axis-Kollimationslinse dienenden Zylinderlinse 20 ausgebildet ist.

In Strahlrichtung beziehungsweise Z-Richtung ist sich daran anschließend eine erfindungsgemäße Vorrichtung 21 zur optischen Strahltransformation vorgesehen. Diese Vorrichtung besteht ebenfalls aus zwei Teilen 22, 23, die wie die Teile 6, 7 der Vorrichtung 5 sowohl auf der Eintrittsfläche als auch auf der Austrittsfläche Zylinderlinsen aufweisen, die im Prinzip den Zylinderlinsen 13, 14, 15, 16 entsprechen, die aus Fig. 3a und Fig. 3b deutlich ersichtlich sind.

In positiver Z-Richtung schließt sich daran ein Linsenarray 24 an, das lediglich auf seiner Austrittsfläche Zylinderlinsen aufweist.

In positiver Z-Richtung daran anschließend ist eine Kollimierlinse 25 angeordnet, die der Kollimierlinse 11 im Wesentlichen entspricht.

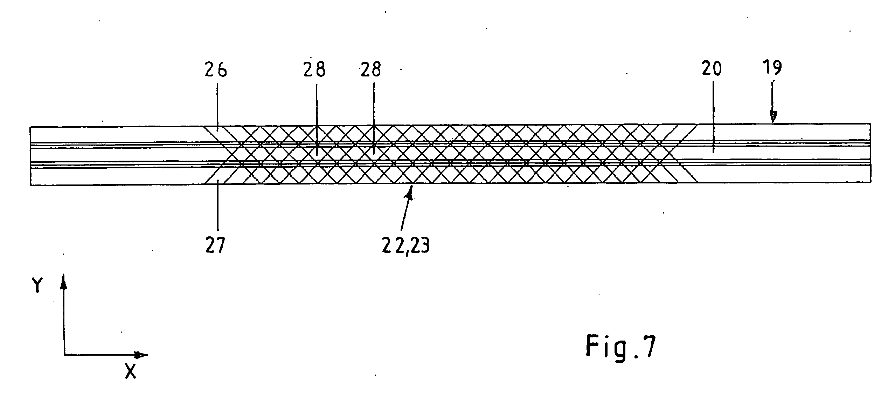

Fig. 7 zeigt noch einmal die Teile 22, 23 der Vorrichtung 21 zusammen mit dem Kollimationsmittel 19 in einer Ansicht in negativer Z-Richtung. Insbesondere ist dabei ersichtlich, dass die einzelnen Zylinderlinsen, von denen die Zylinderlinsen 26 auf der Austrittsfläche des Teils 22 und die Zylinderlinsen 27 auf der Austrittfläche des Teils 23 mit Bezugszeichen versehen sind, im Wesentlichen quadratische Aperturen 28 schaffen, die in Z-Richtung mit der Zylinderlinse 20 des Kollimationsmittels 19 fluchten. Das Licht des Halbleiterlasers muss durch diese relativ kleinen quadratischen Aperturen 28 hindurchtreten, so dass die Verkleinerung des Querschnitts des Lichtstrahles 3 beim Hindurchtritt durch die Vorrichtung 21 beziehungsweise die Vorrichtung 5 sinnvoll ist.

**Patentansprüche**

1. Vorrichtung zur optischen Strahltransformation, umfassend ein erstes Teil (6, 22) und ein zweites Teil (7, 23), die in Ausbreitungsrichtung (Z) eines zu transformierenden Lichtstrahls (3) hintereinander angeordnet sind, wobei die beiden Teile (6, 7; 22, 23) jeweils eine Eintrittsfläche und eine Austrittsfläche aufweisen, wobei auf jeder der Eintritts- und Austrittsflächen der beiden Teile (6, 7; 22, 23) eine Mehrzahl von Zylinderlinsen angeordnet ist, wobei die Vorrichtung (5, 21) derart gestaltet ist, dass die Divergenz eines durch die Vorrichtung (5, 21) hindurchtretenden Lichtstrahles (3) eines Lasers in einer ersten Richtung (Y) mit der Divergenz in einer dazu senkrechten zweiten Richtung (X) getauscht wird, **dadurch gekennzeichnet, dass** die Zylinderachsen der Zylinderlinsen (13, 14) auf der Eintritts- und Austrittsfläche des ersten Teils (6, 22) senkrecht zu den Zylinderachsen der Zylinderlinsen (15, 16) auf der Eintritts- und Austrittsfläche des zweiten Teils (7, 23) ausgerichtet sind, wobei die Zylinderlinsen (13) auf der Eintrittsfläche des ersten Teils (6, 22) eine erste Brennweite $f_1$ aufweisen, wobei die Zylinderlinsen (14) auf der Austrittsfläche des ersten Teils (6, 22) eine zweite Brennweite $f_2$ aufweisen, wobei die Zylinderlinsen (15) auf der Eintrittsfläche des zweiten Teils (7, 23) eine dritte Brennweite $f_3$ aufweisen, wobei die Zylinderlinse (16) auf der Austrittsfläche des zweiten Teils (7, 23) eine vierte Brennweite $f_4$ aufweisen wobei für die Brennweiten $f_1$ bis $f_4$ gilt:

$$f_1 = 2 \times f_2$$

$$f_3 = 2 \times f_1 + 2 \times f_2$$

$$f_3 = 2 \times f_4,$$

$f_1 = 2 \times f_2$ $f_3 = 2 \times f_1 + 2 \times f_2$ $f_3 = 2 \times f_4$, wobei der Abstand zwischen den Zylinderlinsen (13) auf der Eintrittsfläche und den Zylinderlinsen (14) auf der Austrittsfläche des ersten Teils (6, 22) der Summe der ersten und der zweiten Brennweite ($f_1$, $f_2$) entspricht, wobei der Abstand zwischen den Zylinderlinsen (15) auf der Eintrittsfläche und den Zylinderlinsen (16) auf der Austrittsfläche des zweiten Teils (7, 23) der vierten Brennweite $f_4$ entspricht, wobei der Abstand zwischen den Zylinderlinsen (14) auf der Austrittsfläche des ersten Teils (6, 22) und den Zylinderlinsen (15) auf der Eintrittsfläche des zweiten Teils (7, 23) der zweiten Brennweite $f_2$ entspricht, und wobei mindestens eine der Eintritts- und/oder Austrittsflächen der beiden Teile (6, 7; 22, 23) mit einer Mehrzahl von konkaven Zylinderlinsen (16) versehen ist, so dass die Vorrichtung (5, 21) zur optischen Strahltransformation derart gestaltet ist, dass sie ein Abbild einer vor der Vorrichtung (5, 21) angeordneten ersten Ebene des mindestens einen von ihr zu transformierenden Lichtstrahls (3) hinsichtlich zweier voneinander und zur Ausbreitungsrichtung (Z) des Lichtstrahles (3) senkrechter Richtungen (X', Y') in einer zweiten Ebene erzeugen kann, die in Ausbreitungsrichtung (Z) des Lichtstrahles (3) hinter der ersten Ebene angeordnet ist.

2. Vorrichtung nach Anspruch 1, **dadurch gekennzeichnet, dass** die Vorrichtung derart gestaltet ist, dass die Querschnittsfläche des mindestens einen Lichtstrahles (3) in der Vorrichtung (5, 21) zur optischen Strahltransformation verkleinert wird.

3. Vorrichtung nach einem der Ansprüche 1 oder 2, **dadurch gekennzeichnet, dass** die Ebene, in der das Abbild des zu transformierenden Lichtstrahles (3) erzeugt werden kann, eine zu der Ausbreitungsrichtung (Z) senkrechte Ebene ist.

4. Vorrichtung nach einem der Ansprüche 1 bis 3, **dadurch gekennzeichnet, dass** die Zylinderlinsen (13, 14, 15, 16) mit der zweiten Richtung (X) einen Winkel ($\alpha$) von + 45° und/oder - 45° einschließen.

5. Vorrichtung nach einem der Ansprüche 1 bis 4, **dadurch gekennzeichnet, dass** die Eintritts- und Austrittsflächen der Vorrichtung (5, 21) eine im Wesentlichen langgestreckte, vorzugsweise rechteckige Form aufweisen, wobei die Längsrichtung der Eintritts- und der Austrittsflächen im Wesentlichen der zweiten Richtung (X) entspricht.

6. Vorrichtung nach einem der Ansprüche 2 bis 5, **dadurch gekennzeichnet, dass** für mindestens eines der Teile (6, 7; 22, 23) die Brennweiten der Zylinderlinsen (13, 14, 15, 16) auf ihren Eintritts- und/oder Austrittsflächen unterschiedlich sind.

7. Anordnung zur optischen Strahltransformation umfassend:

   - mindestens eine als Laser ausgebildete Lichtquelle (1, 18), die mindestens einen Lichtstrahl (3) aussenden kann, wobei der mindestens eine Lichtstrahl (3) in einer ersten Richtung (Y) eine größere Divergenz als in einer dazu senkrechten zweiten Richtung (X) aufweist;
   - ein Kollimationsmittel (4, 19), das die Divergenz des mindestens einen Lichtstrahles (3) in der ersten Richtung (Y) zumindest verringern kann;
   - eine Vorrichtung (5, 21) zur optischen Strahltransformation, die in Ausbreitungsrichtung (Z) des mindestens einen Lichtstrahles (3) hinter dem Kollimationsmittel (4, 19) angeordnet ist, wobei die Vorrichtung (5, 21) derart gestaltet ist, dass die Divergenz des durch die Vorrichtung (5, 21) hindurchtretenden mindestens einen Lichtstrahles (3) in der ersten Richtung (Y) mit der Divergenz in der dazu senkrechten zweiten Richtung (X) getauscht wird;
   **gekennzeichnet durch** eine Vorrichtung (5, 21) nach einem der Ansprüche 1 bis 6.

8. Anordnung nach Anspruch 7, **dadurch gekennzeichnet, dass** die Anordnung in Ausbreitungsrichtung (Z) des mindestens einen Lichtstrahles (3) hinter der Vorrichtung (5, 21) zur optischen Strahltransformation Kollimiermittel und/oder Fokussiermittel für die Kollimierung und/oder Fokussierung des mindestens einen Lichtstrahles (3, 12) umfasst.

**9.** Anordnung nach einem der Ansprüche 7 oder 8, **dadurch gekennzeichnet, dass** die mindestens eine Lichtquelle (1, 18) als Halbleiterlaservorrichtung, insbesondere als Halbleiterlaserdiodenbarren ausgeführt ist.

**Claims**

**1.** Device for optical beam transformation, comprising a first part (6, 22) and a second part (7, 23) which are arranged in series in the propagation direction (Z) of a light beam (3) to be transformed, the two parts (6, 7; 22, 23) respectively having an entrance surface and an exit surface, a plurality of cylindrical lenses being arranged on each of the entrance and exit surfaces of the two parts (6, 7; 22, 23), the device (5, 21) being fashioned such that the divergence of a laser light beam (3), passing through the device (5, 21), in a first direction (Y) is exchanged with the divergence in a second direction (X) perpendicular thereto, **characterized in that** the cylinder axes of the cylindrical lenses (13, 14) on the entrance and exit surfaces of the first part (6, 22) are aligned perpendicular to the cylinder axes of the cylindrical lenses (15, 16) on the entrance and exit surfaces of the second part (7, 23), the cylindrical lenses (13) on the entrance surface of the first part (6, 22) having a first focal length $f_1$, the cylindrical lenses (14) on the exit surface of the first part (6, 22) having a second focal length $f_2$, the cylindrical lenses (15) on the entrance surface of the second part (7, 23) having a third focal length $f_3$, the cylindrical lenses (16) on the exit surface of the second part (7, 23) having a fourth focal length $f_4$, wherein it holds true for the focal lengths $f_1$ to $f_4$ that:

$$f_1 = 2 \times f_2$$

$$f_3 = 2 \times f_1 + 2 \times f_2$$

$$f_3 = 2 \times f_4,$$

the spacing between the cylindrical lenses (13) on the entrance surface and the cylindrical lenses (14) on the exit surface of the first part (6, 22) corresponding to the sum of the first and the second focal lengths ($f_1$, $f_2$), the spacing between the cylindrical lenses (15) on the entrance surface and the cylindrical lenses (16) on the exit surface of the second part (7, 23) corresponding to the fourth focal length $f_4$, the spacing between the cylindrical lenses (14) on the exit surface of the first part (6, 22) and the cylindrical lenses (15) on the entrance surface of the second part (7, 23) corresponding to the second focal length $f_2$, and at least one of the entrance and/or exit surfaces on the two parts (6, 7; 22, 23) being provided with a plurality of concave cylindrical lenses (16) such that the device (5, 21) for optical beam transformation is fashioned in such a way that it can produce an image of a first plane, arranged upstream of the device (5, 21), of the at least one light beam (3), which is to be transformed by said device, with regard to two directions (X', Y') perpendicular to one another and to the propagation direction (Z) of the light beam (3) in a second plane, which is arranged downstream of the first plane in the propagation direction (Z) of the light beam (3).

**2.** Device according to Claim 1, **characterized in that** the device is fashioned in such a way that the cross-sectional surface of the at least one light beam (3) is reduced in the device (5, 21) for optical beam transformation.

**3.** Device according to either of Claims 1 and 2, **characterized in that** the plane in which the image of the light beam (3) to be transformed can be produced is a plane perpendicular to the propagation direction (Z).

**4.** Device according to one of Claims 1 to 3, **characterized in that** the cylindrical lenses (13, 14, 15, 16) enclose an angle ($\alpha$) of +45° and/or -45° with the second direction (X).

**5.** Device according to one of Claims 1 to 4, **characterized in that** the entrance and exit surfaces of the device (5, 21) have a substantially elongated, preferably rectangular shape, the longitudinal direction of the entrance and the exit surfaces corresponding substantially to the second direction (X).

**6.** Device according to one of Claims 2 to 5, **characterized in that** for at least one of the parts (6, 7; 22, 23) the focal lengths of the cylindrical lenses (13, 14, 15, 16) on the entrance and/or exit surfaces thereof are different.

**7.** Arrangement for optical beam transformation, comprising:

- at least one light source (1, 18) which is designed as a laser and can emit at least one light beam (3), the at least one light beam (3) having in a first direction (Y) a larger divergence than in a second direction (X) perpendicular thereto;
- a collimation means (4, 19) which can at least decrease the divergence of the at least one light beam (3) in the first direction (Y); and

- a device (5, 21) for the optical beam transformation which is arranged downstream of the collimation means (4, 19) in the propagation direction (Z) of the at least one light beam (3), the device (5, 21) being fashioned in such a way that the divergence of the at least one light beam (3), passing through the device (5, 21), in the first direction (Y) is exchanged with the divergence in the second direction (X) perpendicular thereto;

**characterized by** a device (5, 21) according to one of Claims 1 to 6.

8. Arrangement according to Claim 7, **characterized in that** in the propagation direction (Z) of the at least one light beam (3) downstream of the device (5, 21) for optical beam transformation the arrangement has collimating means and/or focusing means for the collimation and/or focusing of the at least one light beam (3, 12).

9. Arrangement according to either of claims 7 and 8, **characterized in that** the at least one light source (1, 18) is designed as a semiconductor laser device, in particular as a semiconductor laser diode bar.

**Revendications**

1. Appareillage pour la transformation optique de faisceaux, comprenant une première partie (6, 22) et une deuxième partie (7, 23) disposées l'une derrière l'autre dans la direction de propagation (Z) d'un faisceau lumineux à transformer (3), dans lequel les deux parties (6, 7 ; 22, 23) présentent respectivement une surface d'entrée et une surface de sortie, dans lequel sur chacune des surfaces d'entrée et de sortie des deux parties (6, 7 ; 22, 23) est disposée une pluralité de lentilles cylindriques, dans lequel l'appareillage (5, 21) est réalisé de telle sorte que la divergence d'un faisceau lumineux (3) d'un laser traversant l'appareillage (5, 21) dans une première direction (Y) est échangé avec la divergence dans une deuxième direction (X) qui lui est perpendiculaire, **caractérisé en ce que** les axes des cylindres des lentilles cylindriques (13, 14) sur les surfaces d'entrée et de sortie de la première partie (6, 22) sont orientés perpendiculairement aux axes des cylindres des lentilles cylindriques (15, 16) sur les surfaces d'entrée et de sortie de la deuxième partie (7, 23), dans lequel les lentilles cylindriques (13) sur la surface d'entrée de la première partie (6, 22) présentent une première distance focale $f_1$, dans lequel les lentilles cylindriques (14) sur la surface de sortie de la première partie (6, 22) présentent une deuxième distance focale $f_2$, dans lequel les lentilles cylindriques (15) sur la surface d'entrée de la deuxième partie (7, 23) présentent une troisième distance focale $f_3$, dans lequel les lentilles cylindriques (16) sur la surface de sortie de la deuxième partie (7, 23) présentent une quatrième distance focale $f_4$, les distances focales $f_1$ à $f_4$ valant :

$$f_1 = 2 \times f_2$$

$$f_3 = 2 \times f_1 + 2 \times f_2$$

$$f_3 = 2 \times f_4$$

dans lequel la distance entre les lentilles cylindriques (13) sur la surface d'entrée et les lentilles cylindriques (14) sur la surface de sortie de la première partie (6, 22) correspond à la somme de la première et de la deuxième distance focale ($f_1$, $f_2$), dans lequel la distance entre les lentilles cylindriques (15) sur la surface d'entrée et les lentilles cylindriques (16) sur la surface de sortie de la deuxième partie (7, 23) correspond à la quatrième distance focale ($f_4$), dans lequel la distance entre les lentilles cylindriques (14) sur la surface de sortie de la première partie (6, 22) et les lentilles cylindriques (15) sur la surface d'entrée de la deuxième partie (7, 23) correspond à la deuxième distance focale ($f_2$), et dans lequel au moins une des surfaces d'entrée et/ou de sortie des deux parties (6, 7 ; 22, 23) est pourvue d'une pluralité de lentilles cylindriques concaves (16), de telle sorte que l'appareillage (5, 21) pour la transformation optique de faisceaux est réalisé de manière à pouvoir générer dans un deuxième plan disposé derrière le premier plan dans la direction de propagation (Z) du faisceau lumineux (3), une représentation d'un premier plan disposé devant l'appareillage (5, 21) d'au moins un faisceau lumineux (3) que celui-ci doit transformer au niveau de deux directions mutuellement perpendiculaires (X', Y') et perpendiculaires à la direction de propagation (Z) du faisceau lumineux (3).

2. Appareillage selon la revendication 1, **caractérisé en ce que** l'appareillage est réalisé de telle sorte que la surface de coupe transversale d'au moins un faisceau lumineux (3) est réduite dans l'appareillage (5, 21) pour la transformation optique de faisceaux.

3. Appareillage selon une des revendications 1 ou 2, **caractérisé en ce que** le plan dans lequel la représentation du faisceau lumineux à transformer (3) peut être générée, est un plan perpendiculaire à la direction de propagation (Z).

4. Appareillage selon une des revendications 1 à 3, **caractérisé en ce que** les lentilles cylindriques (13, 14, 15, 16) forment avec la deuxième direction (X), un angle (α) compris entre +45° et/ou -45°.

5. Appareillage selon une des revendications 1 à 4, **caractérisé en ce que** les surfaces d'entrée et de sortie de l'appareillage (5, 21) présentent une forme essentiellement allongée, de préférence rectangulaire, la direction longitudinale des surfaces d'entrée et de sortie correspondant essentiellement à la deuxième direction (X).

6. Appareillage selon une des revendications 2 à 5, **caractérisé en ce que** pour au moins une des parties (6, 7 ; 22, 23), les distances focales des lentilles cylindriques (13, 14, 15, 16) sont différentes sur leurs surfaces d'entrée et/ou de sortie.

7. Assemblage pour la transformation optique de faisceaux, comprenant :

   - au moins une source lumineuse (1, 18) sous la forme d'un laser, pouvant émettre au moins un faisceau lumineux (3), ce faisceau lumineux (3) au moins présentant une divergence plus importante dans une première direction (Y) que dans une deuxième direction (X) qui lui est perpendiculaire ;
   - un moyen de collimation (4, 19) pouvant au moins réduire la divergence de ce faisceau lumineux (3) au moins, dans la première direction (Y) ;
   - un appareillage (5, 21) pour la transformation optique de faisceaux, disposé derrière le moyen de collimation (4, 19) dans la direction de propagation (Z) de ce faisceau lumineux (3) au moins, l'appareillage (5, 21) étant formé de telle sorte que la divergence de ce faisceau lumineux (3) au moins, traversant l'appareillage (5, 21) dans la première direction (Y) est échangé avec la divergence dans la deuxième direction (X) qui lui est perpendiculaire ; **caractérisé par** un appareillage (5, 21) selon une des revendications 1 à 6.

8. Assemblage selon la revendication 7, **caractérisé en ce que** l'assemblage comprend derrière l'appareillage (5, 21) pour la transformation optique de faisceaux dans la direction de propagation (Z) de ce faisceau lumineux (3) au moins, des moyens de collimation et/ou des moyens de focalisation pour la collimation et/ou la focalisation de ce faisceau lumineux (3, 12) au moins.

9. Assemblage selon une des revendications 7 ou 8, **caractérisé en ce que** la source lumineuse (1, 18) au moins, est réalisée sous la forme d'un appareillage laser semi-conducteur, notamment sous la forme de barres de diodes laser semi-conductrices.

Fig. 1a

Fig. 1b

EP 1 528 425 B1

Fig.2

Fig.3a

Fig.3b

EP 1 528 425 B1

Fig.4a

Fig.4b

EP 1 528 425 B1

Fig. 5

Fig.6

26  28  28  20  19

27  22,23

Y
X

Fig.7

EP 1 528 425 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1006382 A1
- DE 10113019 A1
- EP 1176450 A2
- US 4203652 A